# EUROPÄISCHE PATENTSCHRIFT

(11) **EP 1 036 212 B1**
(45) Veröffentlichungstag und Bekanntmachung des Hinweises auf die Patenterteilung: **13.06.2001**
(21) Anmeldenummer: 98963374.8
(22) Anmeldetag: 19.11.1998
(51) Int. Cl.: C23C 14/56

(54) **EINRICHTUNG ZUR VAKUUMBESCHICHTUNG VON GLEITLAGERN**
DEVICE FOR VACUUM COATING SLIDE BEARINGS
DISPOSITIF DE REVETEMENT SOUS VIDE DE PALIERS LISSES

(30) Priorität: 03.12.1997 DE 19753656
(43) Veröffentlichungstag der Anmeldung: 20.09.2000
(73) Patentinhaber: Federal-Mogul Wiesbaden GmbH & Co.KG, 65201 Wiesbaden (DE)
(72) Erfinder: ANDLER, Gerd, D-60594 Frankfurt (DE); WIXWAT-ERNST, Wolfgang, D-65197 Wiesbaden (DE); METZNER, Christoph, D-01474 Pappritz (DE); HEINSS, Jens-Peter, D-01157 Dresden (DE); GOEDICKE, Klaus, D-01307 Dresden (DE); SCHILLER, Siegfried, D-01324 Dresden (DE)
(86) Internationale Anmeldenummer: DE9803455
(87) Internationale Veröffentlichungsnummer: WO9928523

(56) Entgegenhaltungen:
- DE-A- 3 717 712
- DE-A- 19 514 836
- US-A- 4 824 309

## Beschreibung

Die Erfindung betrifft eine Einrichtung zur Vakuumbeschichtung von Gleitlagern. Gleitlager - auch Lagerschalen genannt - weisen konkav gekrümmte Oberflächen auf, wobei die innere, der Welle zugeordnete Fläche mit einem Schichtsystem versehen wird. Die Beschichtung erfolgt in Vakuumbeschichtungsanlagen. Derartige Gleitlager werden hauptsächlich hochbelastet im Maschinen- und Fahrzeugbau eingesetzt.

Seit langem sind Durchlaufanlagen zur Vakuumbeschichtung von Substraten bekannt. Die Substrate können unterschiedliche Abmessungen, Materialien und Geometrien besitzen, z.B. Bänder, Bauteile oder Glassubstrate sein. Auf diese Substrate werden in einem Durchlauf eine oder mehrere Schichten aufgebracht. Dazu werden die Substrate über Schleusen in die jeweilige Durchlaufanlage eingebracht. In Abhängigkeit vom aufzubringenden Schichtsystem wird üblicherweise eine Vorbehandlung in einer entsprechenden Vakuumkammer durchgeführt, bevor anschließend in einer oder mehreren Beschichtungskammern das entsprechende Schichtsystem aufgebracht wird. Nach erfolgter Beschichtung verlässt das Substrat über eine Schleuse die Durchlaufanlage. In derartigen Luft-zu-Luft-Durchlaufanlagen wird das gesamte Schichtsystem aufgebracht. Die Substrate werden quasi konstant durch die Anlage bewegt.

Werden in einer derartigen Durchlaufanlage ebene Substrate, wie z.B. Bänder oder aneinander gereihte Glasplatten beschichtet, so ist es auch bekannt, unterschiedliche Schichten bezüglich des Materials und der Dicke mit unterschiedlichen Vakuumbeschichtungsverfahren aufzubringen. So ist es bekannt, auf Bänder in einem Durchlauf zwei Schichten aufzustäuben und danach eine Schicht aufzudampfen [Surface and Coatings Technology, 93(1997) S. 51-57].

Die Durchlaufanlage ist für bandförmiges Material geeignet, welches selbst bei den unterschiedlichen Beschichtungsprozessen mit gleicher Geschwindigkeit durch die Anlage geführt wird. Es besteht aber der Nachteil, dass, diese Anlage und das mit ihr ausgeführte Verfahren nicht geeignet ist, wenn Substrate beschichtet werden, deren Geometrie und Schichtparameter sowie Schichtmaterialien eine unterschiedliche Transportgeschwindigkeit und ein differenziertes Transportregime erfordern.

Es ist weiterhin eine Durchlaufanlage zum Beschichten von Turbinenschaufeln bekannt (DE 195 37 092 C1). In dieser Durchlaufanlage werden auf die Turbinenschaufeln hochtemperaturbeständige Schichten aufgebracht. Das Aufbringen dieser Schichten erfolgt bei hohen Temperaturen durch Elektronenstrahlverdampfen, wobei die Turbinenschaufeln vor der Beschichtung auf Temperaturen von ca. 1000 °C geheizt werden müssen. Die Beschichtung bei diesen Temperaturen erzwingt einen großen apparativen Aufwand, der nur für derartige spezielle Anwendungen, die Beschichtung von Turbinenschaufeln, gerechtfertigt ist. Die Beschichtung erfolgt nur durch ein einziges Verfahren.

Weiterhin sind Verfahren und Anlagen zur Beschichtung von Gleitlagern bekannt. Diese bestehen als Chargenanlage meist aus einer Vakuumkammer. In dieser wird nach einer Vorbehandlung auf ein bereits beschichtetes Gleitlager die abschließende Gleitschicht durch Zerstäuben aufgebracht. Diese Gleitschicht bestimmt wesentlich die Eigenschaften des Gleitlagers. Von der Qualität der aufgebrachten Gleitschicht ist es mit abhängig, ob das Gleitlager die gestellten Anforderungen erfüllt (DE 36 06 529 C2; AT 392 291 B).

Nachteilig ist, dass verfahrensbedingt beim Aufbringen der Gleitschicht durch Zerstäuben ein sehr hoher Energieeintrag in die Gleitlager erfolgt. Die Gleitschicht - in der Regel ein zinnhaltiges Material- kann aufgrund des niedrigschmelzenden Zinns nicht bei beliebig hohen Temperaturen aufgebracht werden. Aus diesem Grund ist es für das Aufbringen qualitativ hochwertiger Gleitschichten notwendig, die verfahrensbedingt eingebrachte Energie durch Kühlung, z.B. Ölkühlung, auf ein tolerierbares Maß zu reduzieren. Dazu wird jedem Träger, in dem die Gleitlager während des Aufstäubens der Schicht gehaltert sind, Kühlflüssigkeit zu- und abgeführt. In Chargenanlagen ist die Art der Kühlung problemlos möglich. Dagegen ist die Beschichtung von Gleitlagern in einer als Durchlaufanlage ausgebildeten Beschichtungsanlage, in der in Vakuumfolge mehrere Schichten aufzubringen sind, mit ihren durch Schleusen getrennten Vakuumkammern mit einer üblichen Kühlung mittels Flüssigkeit nur sehr aufwendig möglich.

Ein weiterer Nachteil von Chargenanlagen besteht darin, dass sie - bedingt durch den Magazinbetrieb - eine geringere Produktivität als Durchlaufanlagen mit kontinuierlichem oder quasi kontinuierlichem Betrieb besitzen. Die geringere Produktivität von Chargenanlagen ergibt sich aus dem diskontinuierlichen Betrieb und dem häufigen Ent- und Belüften großer Teile der Anlage.

Es wurde ein Verfahren zur Herstellung von Gleitlagern vorgestellt, bei dem die Gleitschicht durch Elektronenstrahlverdampfen aufgebracht wird. Mit diesem Verfahren wird es ermöglicht, die Gleitschicht von Gleitlagern mit einer gegenüber dem Aufstäuben höheren Rate aufzubringen und gleichzeitig den Energieeintrag in die Gleitlager zu verringern (DE 195 14 836 A1).
Dieses Verfahren ist jedoch noch nicht industriell zur Anwendung gekommen und derzeit ist keine Anlage zur Durchführung dieses Verfahrens für Gleitlager bekannt, in der dieses Verfahren unter Industriebedingungen ausführbar ist.

Der Erfindung liegt die Aufgabe zugrunde, eine Einrichtung zur Vakuumbeschichtung von Gleitlagern zu schaffen, mit der es möglich ist, mehrere Schichten aus unterschiedlichem Material in unterschiedlicher Dicke hochproduktiv aufzubringen. Die Einrichtung soll einen hohen Durchsatz bei geringen Kosten ermöglichen. Sie soll die Einhaltung verfahrenswichtiger Parameter in engen Toleranzgrenzen gewährleisten. Die Temperatur der zu beschichtenden Gleitlager ist während des Prozesses in engen Grenzen konstant zu halten. Die Anlage soll geeignet sein, mehrere zum Gesamtprozess erforderliche Vakuumverfahren auszuüben.

Erfindungsgemäß wird die Aufgabe durch die Merkmale des Patentanspruchs 1 gelöst. Weitere vorteilhafte Ausgestaltungen sind in den Ansprüchen 2 bis 17 beschrieben.

Die als Durchlaufanlage ausgebildete Einrichtung ist derart aufgebaut, dass mehrere Vakuumkammern aneinander angeordnet sind, wobei in jeder Vakuumkammer für den in ihr auszuübenden Prozessschritt erforderliche Mittel angeordnet sind. Die Einrichtung besitzt weiterhin je eine den Vakuumprozesskammern vor- und nachgeschaltete Schleusenkammer für das Ein- und Ausbringen von Trägerkörpern. Die Träge rkörper, die temperierbar ausgebildet sind, dienen der Aufnahme der Gleitlager und sind auf einer Transportbahn durch die gesamte Einrichtung bewegbar.

Die Vakuumkammern mit ihren prozessbedingten Mitteln sind mindestens eine Vorbehandlungskammer mit mindestens einer Ätzvorrichtung, eine erste Beschichtungskammer mit mindestens einer Zerstäubungsquelle und eine zweite Beschichtungskammer mit mindestens einem Elektronenstrahlverdampfer. Die Vakuumkammer mit dem Elektronenstrahlverdampfer ist dabei so ausgebildet, dass sich zu beiden Seiten des Bedampfungsbereiches in der Beschichtungskammer je ein Pufferbereich befindet.

Erfindungswesentlich ist die temperierbare Ausgestaltung der Trägerkörper bzw. die Temperiermöglichkeit der Gleitlager.

Dazu sind die Trägerkörper derart ausgebildet, dass die Gleitlager in einem der Aufnahme dienenden Teil der Trägerkörper formschlüssig aufgenommen und mit einstellbarer Kraft gehaltert werden. Durch die form- und kraftschlüssige Aufnahme wird ein guter Wärmeübergang von den Gleitlagern auf den Trägerkörper erreicht. Damit ist gewährleistet, dass die in die Gleitlager prozessbedingt eingebrachte Wärme in den Trägerkörper abgeleitet und eine zu große Erwärmung der Gleitlager verhindert wird.
Die Dimensionierung und Ausgestaltung des der Temperierung dienenden Teils der Trägerkörper trägt hauptsächlich dazu bei, dass nicht nur die eingebrachte Wärme gespeichert wird, sondern die Temperatur der Gleitlager in einem bestimmten Bereich einstellbar ist. So wird durch diese Ausgestaltung der Trägerkörper gewährleistet, dass die Temperatur der Gleitlager während eines Beschichtungsprozesses - Zerstäuben oder Verdampfen - auf einen bestimmten Wert eingestellt ist und in engen Grenzen konstant bleibt. D.h., die Größe, Form und Materialart dienen auf der Grundlage von Berechnungen und Versuchen der Temperierung. Insbesondere beim Aufbringen von Schichten, die niedrigschmelzende Metalle enthalten, ist für die Herstellung qualitativ hochwertiger Schichten ein engtolerierter Temperaturbereich zwingend notwendig. So muss beispielsweise beim Aufbringen einer AISn-Gleitschicht mittels Elektronenstrahlverdampfen die Temperatur der Gleitlager zwischen 140 °C und 160 °C betragen.
Die temperierbare Ausgestaltung der Trägerkörper trägt wesentlich zur Kombination der unterschiedlichen Beschichtungsverfahren bei. Während üblicherweise Kühlelemente dazu dienen, Wärme abzuführen, ermöglichen die temperierbaren Trägerkörper einerseits beim Ätzen und Beschichten in den ersten Kammern die Aufnahme von Wärme, während sie andererseits in der zweiten Beschichtungskammer auch als Wärmepuffer dienen und die Wärme an die Gleitlager abgeben können. Sie gewährleisten damit, dass in der zweiten Beschichtungskammer die Temperatur der Gleitlager in einem vorgegebenen eng tolerierten Temperaturbereich gehalten wird. Das ist insbesondere beim Aufbringen von Schichten mit niedrigschmelzenden Metallen ausschlaggebend für die Schichtqualität und damit für die Qualität des gesamten Gleitlagers. So ist es weiterhin durch die Einstellung unterschiedlicher Temperaturen in den Trägerkörpern erst möglich, Schichten aus unterschiedlichen Materialien jeweils mit ausreichender Qualität aufzubringen.

Ein weiteres wesentliches Merkmal der Erfindung ist die Anordnung von Pufferbereichen. Jedes Beschichtungsverfahren besitzt seinen eigenen zeitlichen Verfahrensablauf, der nicht auf ein anderes Beschichtungsverfahren übertragbar ist. So erfordert jedes Beschichtungsverfahren eine andere Bewegung der Gleitlager über die Beschichtungsquelle. Während beim Ätzen und Zerstäuben stationär und diskontinuierlich geätzt bzw. beschichtet wird und somit nur ein schrittweises Bewegen der Trägerkörper verlangt wird, erfordert das Elektronenstrahlverdampfen eine kontinuierliche Betriebsweise und damit eine andere, diesem Teilprozess angepasste Bewegung. Diese kann wiederum gleichförmig oder ungleichförmig sein. Des Weiteren sind die Verweilzeiten in den einzelnen Beschichtungskammern unterschiedlich. Durch die Anordnung von Pufferbereichen im Zusammenhang mit einem Steuerprogramm wird es erst ermöglicht, die zwei unterschiedlichen Beschichtungsverfahren - diskontinuierliches Aufstäuben und kontinuierliches Aufdampfen - in einer Einrichtung in einem Durchlauf miteinander zu verbinden. Die Anordnung von Pufferbereichen oder Pufferkammern ist somit ein wichtiges Bindeglied, um einen Ausgleich zwischen unterschiedlichen Bewegungsabläufen und den völlig unterschiedlichen Arbeitsdruckbereichen dieser zwei Verfahren herzustellen, und somit einen kontinuierlichen Durchlauf der Gleitelemente von Atmosphäre zu Atmosphäre zu ermöglichen.

Somit ist es überraschenderweise mit der erfindungsgemäßen Einrichtung erst möglich, Gleitlager in Vakuumfolge mit mehreren Schichten mit unterschiedlichen Prozessen in einem Durchlauf ohne zwischenzeitliches Aussetzen an Atmosphäre hochproduktiv zu versehen.

Vorteilhafte Ausgestaltungen der Einrichtung bestehen neben der Ausgestaltung der Trägerkörper darin, dass der temperierbare Teil der Trägerkörper aus Kupfer besteht. Es sind aber auch alle anderen Materialien denkbar, die eine gute Wärmeleitfähigkeit und eine hohe spezifische Wärmekapazität besitzen. Die Anordnung der Gleitlager in den Trägerkörpern kann nebeneinander und in einer oder mehreren Reihen in Transportrichtung oder rechtwinklig dazu erfolgen.

Die Vorbehandlungskammer verfügt zweckmäßigerweise über ein Gaseinlasssystem, so dass plasmagestützte Prozesse und auch reaktive Vorbehandlungen durchführbar sind. Die Ätzvorrichtung ist mit Magnetfeld ausgestattet oder es können separate Plasmaquellen, z.B. Hohlkatoden angeordnet sein.
Als Zerstäubungsquelle der ersten Beschichtungskammer sind alle bekannten Zerstäubungsquellen mit und ohne Magnetfeld einsetzbar.
Als Elektronenstrahlverdampfer sind ebenfalls alle bekannten Elektronenstrahlquellen; vorzugsweise Axialkanonen, einsetzbar. Der Verdampfertiegel kann als Ein- oder Mehrtiegelverdampfer ausgeführt sein, wobei er an die Geometrie der zu beschichtenden Gleitelemente angepasst ist, um eine homogene Beschichtung zu erzielen. Das Verdampfungsmaterial kann in Form von Draht, Schüttgut oder als Strang durch den Verdampfertiegelboden zugeführt werden.

Eine Vorrichtung zum Temperieren ist vorteilhafterweise vor der eingangsseitigen Schleusenkammer angeordnet. Sie kann aber auch an jeder beliebigen Stelle der Einrichtung oder außerhalb dieser angeordnet werden. Ebenso kann die Temperierung in jeder Vakuumkammer vorgenommen werden. Es muss nur gewährleistet sein, dass die Gleitlager zum Zeitpunkt des Aufbringens der Gleitschicht eine Temperatur im vorgegebenen Temperaturbereich besitzen. Die Temperierung kann vorzugsweise unter Atmosphärendruck durch flüssige oder gasförmige Medien erfolgen. Die Zuführung und Abführung des Mediums erfolgt in bekannter Weise. Es ist ebenfalls möglich, entsprechende Temperierelemente am Prozessort im Vakuum anzuordnen, um eine Temperierung durch Anpressen bzw. Anlegen dieser Temperierelemente zu erreichen.
Es ist besonders zweckmäßig, eine zusätzliche Temperierungsvorrichtung nach der Entladestation zur Kühlung der Trägerkörper anzuordnen.
Alle Vakuumkammern sind durch Vakuumpumpen evakuierbar. Ein Steuer- und Kontrollsystem gewährleistet die Prozessabfolge jeweils in Abhängigkeit von der durchzuführenden Beschichtung.

An einem Ausführungsbeispiel wird die Einrichtung näher beschrieben. Die zugehörige Zeichnung zeigt einen Schnitt durch eine Einrichtung zum Beschichten von Gleitelementen. In einer Temperierkammer 1 ist eine Vorrichtung zum Temperieren von Trägerkörpern 2, in denen die zu beschichtenden Gleitlager 3 formschlüssig befestigt sind, angeordnet. Temperierelemente werden an die Trägerkörper 2 angepresst. Die Trägerkörper 2 werden dabei auf 90 °C temperiert. An die Temperierkammer 1 schließt sich über ein Vakuumventil 4 eine Schleusenkammer 5 an. Alle Vakuumkammern sind ebenfalls durch Vakuumventile 4 voneinander getrennt. Die Schleusenkammer 5 dient dem Einschleusen der Trägerkörper 2 von Atmosphäre in das Vakuum. Die Trägerkörper 2 sind zum Durchlauf durch die Einrichtung auf einer Transportbahn 6 bewegbar. Der Antrieb ist in jedem Trägerkörper 2 integriert. An die Schleusenkammer 5 schließt sich eine Vorbehandlungskammer 7 an. In dieser ist ein magnetfeldunterstützter Ätzer 8 zur Vorbehandlung der in den Trägerkörpern 2 angeordneten Gleitlager 3 mittels eines intensiven Plasmas angeordnet. Dieses Plasma wird durch ein speziell geformtes Magnetfeld geführt, welches nach dem Magnetronprinzip arbeitet. Die Ätzvorrichtung 8 ist so gestaltet, dass die Trägerkörper 2 mit den Gleitlagern 3 und der Transportbahn 6 auf Erdpotential liegen. Anschließend werden die temperierten Trägerkörper 2 in eine erste Beschichtungskammer 9 weiterbewegt. In dieser ist in einem der Geometrie der Gleitlager 3 angepassten Abstand ein Magnetron 10 mit zu zerstäubendem Target aus NiCr angeordnet. Auf die Gleitlager 3 wird in dieser ersten Beschichtungskammer 9 eine NiCr-Schicht aufgestäubt. Die Bewegung der Trägerkörper 2 durch diese Beschichtungskammer 9 erfolgt diskontinuierlich.
Danach gelangen die Trägerkörper 2 in eine zweite Beschichtungskammer 11, wobei sie zunächst in einem ersten Pufferbereich 12 verweilen. Dieser Pufferbereich 12 dient der Anpassung der unterschiedlichen Transportregime der ersten mit der zweiten Beschichtungskammer 11 und der Anpassung der unterschiedlichen Arbeitsdrücke. Während die Trägerkörper 2 über das Magnetron 10 diskontinuierlich bewegt werden, erfolgt die Bewegung der Trägerkörper 2 durch den Beschichtungsbereich 13 der zweiten Beschichtungskammer 11 kontinuierlich. im Pufferbereich 12 befinden sich mehrere Trägerkörper 2. Ein Transportsteuerprogramm gewährleistet, dass die diskontinuierliche Reihe von Trägerkörpern 2 in eine lückenlose Reihe von Trägerkörpern 2 umgewandelt wird, und dass der Betrieb des Verdampfers kontinuierlich erfolgen kann, d.h. durch diesen Bereich werden mehrere Reihen von Trägerkörpern 2 aneinandergereiht über den Verdampfer bewegt. Anschließend wird über den Pufferbereich 18 die lückenlose Reihe der Trägerkörper 2 wieder in eine diskontinuierlich transportierbare und schleusbare Reihe von Trägerkörpern 2 umgewandelt. in dem Beschichtungsbereich 13 ist ein Elektronenstrahlverdampfer angeordnet. Dieser besteht aus einer Axialelektronenkanone 14, deren Elektronenstrahl 15 in bekannter Weise durch ein Magnetfeld auf in einem Verdampfertiegel 16 befindliches Verdampfungsgut 17 gelenkt wird. Als Verdampfungsgut kommt eine AISn-Legierung zum Einsatz, die in Form von Strangmaterial durch den Boden des Verdampfertiegels 16 aus einem Magazin 17 nachführbar ist. Während die Gleitlager 3 über den Elektronenstrahlverdampfer bewegt werden, wird auf die Gleitlager 3 eine zweite Schicht - eine Gleitschicht - aufgebracht. Über den beschriebenen Pufferbereich 18 und eine weitere Schleusenkammer 19 verlassen die Trägerkörper 2 die Einrichtung, und die fertig beschichteten Gleitlager 3 werden im Ausgabebereich 20 den Trägerkörpern 2 entnommen.

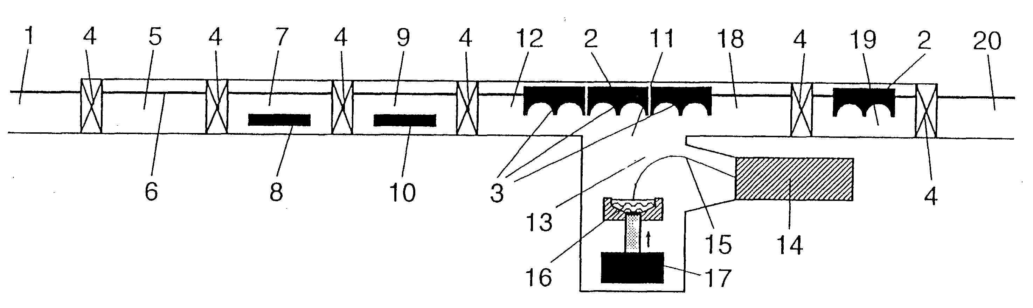

## Patentansprüche

1. Einrichtung zur Vakuumbeschichtung von Gleitlagern mit mindestens einer Zwischenschicht und mindestens einer Gleitschicht, bestehend aus einer Reihe von Vakuumkammern, welche aneinandergereiht und durch Vakuumventile oder Druckstufen getrennt sind, wobei mindestens eine Vakuumkammer als Schleusenkammer zum Einbringen der unbeschichteten Gleitlager und/oder Ausbringen der beschichteten Gleitlager in das bzw. aus dem Vakuum dienen, wobei mindestens eine weitere Vakuumkammer zum Vorbehandeln der unbeschichteten Gleitlager durch einen Plasmaprozess dient und mindestens jeweils eine Vakuumkammer zum Aufbringen der Zwischenschicht und der Gleitschicht dienen, Vakuumpumpen, die mit den Vakuumkammern verbunden sind, Stromversorgungs- und Steuereinrichtungen zur Durchführung der Beschichtungsprozesse, sowie Mittel zum Transport mehrerer Gleitlager auf einer durch die Einrichtung verlaufenden Transportbahn, **dadurch gekennzeichnet,** dass
- die Gleitlager (3) in Trägerkörpern (2) formschlüssig gehalten sind,
- diese Trägerkörper (2) temperierbar sind,
- die Gleitlager (3) mit einer einstellbaren Kraft in den Trägerkörper pressbar sind,
- in Transportrichtung nacheinander mindestens die Schleusenkammer (5), eine Vorbehandlungskammer (7), eine erste Beschichtungskammer (9), eine zweite Beschichtungskammer (11) und eine Schleusenkammer (19) angeordnet sind,
- die Steuereinrichtung derart ausgebildet ist, dass die Trägerkörper (2) mit einer an in jeder Vakuumkammer ablaufenden Teilprozess anpassbaren Transportgeschwindigkeit bewegbar sind,
- in der Vorbehandlungskammer (7) eine Ätzvorrichtung (8) zum stationären magnetfeldunterstützten Plasmaätzen der Gleitlager (3) angeordnet ist,
- in der ersten Beschichtungskammer (9) eine Magnetron-Zerstäubungsquelle (10), in der mindestens ein Target zerstäubt wird, unter den Gleitlagern (3) mit einem an die Geometrie der Gleitlager (3) angepassten Abstand angeordnet ist,
- in der zweiten Beschichtungskammer (11) ein Elektronenstrahlverdampfer mit einem Verdampfertiegel (16) in einem an die Geometrie der Gleitlager (3) angepassten Abstand angeordnet ist,
- vor und hinter dem Bereich, in dem die Gleitlager (3) durch Elektronenstrahlbedampfung beschichtet werden, Pufferbereiche (12; 18) angeordnet sind.

2. Einrichtung nach Anspruch 1, **dadurch gekennzeichnet,** dass in einem Trägerkörper (2) mehrere Gleitlager (3) in mindestens einer Reihe lückenlos nebeneinander so angeordnet sind, dass die Scheitel eine Linie bilden.

3. Einrichtung nach Anspruch 1 und 2, **dadurch gekennzeichnet,** dass die Reihen der Gleitlager (3) in einem Trägerkörper (2) längs oder quer zur Transportrichtung angeordnet sind.

4. Einrichtung nach Anspruch 1 bis 3, **dadurch gekennzeichnet,** dass der Trägerkörper (2) aus zwei Teilen besteht und ein Teil des Trägerkörpers (2) zum Antrieb und zur Verbindung mit der Transportbahn (6) ausgebildet ist, und der andere Teil des Trägerkörpers (2) zur Aufnahme der Gleitlager (3) und Temperierung ausgebildet ist.

5. Einrichtung nach Anspruch 1 bis 3, **dadurch gekennzeichnet,** dass ein Teil des Trägerkörpers (2) zur Temperierung, zum Antrieb und zur Verbindung mit der Transportbahn (6) ausgebildet ist, und der andere Teil des Trägerkörpers (2) zur Aufnahme der Gleitlager (3) ausgebildet ist.

6. Einrichtung nach Anspruch 5, **dadurch gekennzeichnet,** dass der Teil des Trägerkörpers (2), der zur Aufnahme der Gleitlager (3) dient, auswechselbar mit dem Trägerkörper (2) verbunden ist.

7. Einrichtung nach Anspruch 1 bis 6, **dadurch gekennzeichnet,** dass der der Temperierung dienende Teil des Trägerkörpers (2) aus gut wärmeleitendem Material mit hoher spezifischer Wärmekapazität, vorzugsweise Kupfer, besteht.

8. Einrichtung nach Anspruch 1, **dadurch gekennzeichnet,** dass der Elektronenstrahlverdampfer aus einem Verdampfertiegel (16) und einer seitlich davon angeordneten Axial-Elektronenkanone (14) besteht.

9. Einrichtung nach Anspruch 8, **dadurch gekennzeichnet,** dass der Verdampfertiegel (16) im Boden eine Öffnung zum Nachführen von Verdampfungsgut (17) besitzt.

10. Einrichtung nach mindestens einem der Ansprüche 1 bis 9, **dadurch gekennzeichnet,** dass die Pufferbereiche (12; 18) innerhalb der zweiten Beschichtungskammer (11) angeordnet sind.

11. Einrichtung nach mindestens einem der Ansprüche 1 bis 9, **dadurch gekennzeichnet,** dass jeder Pufferbereich (12; 18) in einer getrennten Vakuumkammer angeordnet ist.

12. Einrichtung nach mindestens einem der Ansprüche 1 bis 11, **dadurch gekennzeichnet,** dass zur Temperierung der Trägerkörper (2) vor der Schleusenkammer (5) eine Temperierkammer (1) oder Temperierstation angeordnet ist.

13. Einrichtung nach mindestens einem der Ansprüche 1 bis 12, **dadurch gekennzeichnet,** dass eine Vorrichtung zur Rückführung der Trägerkörper (2) von der ausgangsseitigen Schleusenkammer (19) zur eingangsseitigen Schleusenkammer (5) angeordnet ist.

14. Einrichtung nach mindestens einem der Ansprüche 1 bis 13, **dadurch gekennzeichnet,** dass die Vakuumkammern linear aneinander angeordnet sind und die Trägerkörper (2) linear von der eingangsseitigen bis zur ausgangsseitigen Schleusenkammer (5; 19) transportiert werden.

15. Einrichtung nach mindestens einem der Ansprüche 1 bis 13, **dadurch gekennzeichnet,** dass die Vakuumkammern ringförmig aneinander angeordnet sind und nur eine Vakuumkammer zum Ein- und Ausschleusen der Trägerkörper (2) angeordnet ist.

16. Einrichtung nach Anspruch 1, **dadurch gekennzeichnet,** dass die Ätzvorrichtung so aufgebaut ist, dass die Trägerkörper (2) mit den Gleitlagern (3) auf Erdpotential liegen und das Magnetfeld als magnetronartiger Tunnel ausgebildet ist.

17. Einrichtung nach mindestens einem der Ansprüche 1 bis 16, **dadurch gekennzeichnet,** dass die Ätzvorrichtung (8) feststehende, bogenförmige, elektrisch auf Erdpotential liegende Teile besitzt, die zusammen mit den in den bewegbaren Trägerkörpern (2) befindlichen Gleitelementen (3) einen ringförmig geschlossenen Bereich bilden, der die Plasmaentladung begrenzt, sowie eine wassergekühlte, auf positivem Potential gegen Erde befindliche Gegenelektrode, die eine rückseitig angeordnete, magnetfelderzeugende Einrichtung nach Art eines Magnetrons enthält.

## Claims

1. An apparatus for the vacuum coating of plain bearings with at least one intermediate layer and at least one plain bearing layer, comprising a series of vacuum chambers which are arranged in a row with each other and separated by vacuum valves or pressure stages, wherein at least one vacuum chamber serves as a lock chamber for introducing the uncoated plain bearings into the vacuum and/or discharging the coated plain bearings from the vacuum, wherein at least one further vacuum chamber serves for pre-treatment of the uncoated plain bearings by a plasma process and at least one respective vacuum chamber serves for applying the intermediate layer and the plain bearing layer, vacuum pumps which are connected to the vacuum chambers, power supply and control devices for carrying out the coating processes, and means for transporting a plurality of plain bearings on a transport path passing through the apparatus, characterised in that
- the plain bearings (3) are held in positively locking relationship in carrier bodies (2),
- said carrier bodies (2) are temperature-controllable,
- the plain bearings (3) can be pressed into the carrier body with an adjustable force,
- arranged in succession in the transport direction are at least the lock chamber (5), a pre-treatment chamber (7), a first coating chamber (9), a second coating chamber (11) and a lock chamber (19),
- the control device is such that the carrier bodies (2) are movable at a transport speed which can be adapted to the part of the process which takes place in each vacuum chamber,
- arranged in the pre-treatment chamber (7) is an etching device (8) for stationary magnetic field-assisted plasma etching of the plain bearings (3),
- a magnetron atomisation source (10) in which at least one target is atomised is arranged in the first coating chamber (9) under the plain bearings (3) at a spacing adapted to the geometry of the plain bearings (3),
- arranged in the second coating chamber (11) is an electron beam vaporiser with a vaporiser dish (16) at a spacing adapted to the geometry of the plain bearings (3), and
- buffer regions (12; 18) are arranged upstream and downstream of the region in which the plain bearings (3) are coated by electron beam vapour deposition.

2. Apparatus according to claim 1 characterised in that a plurality of plain bearings (3) are arranged in a carrier body (2) in at least one row in mutually juxtaposed relationship without gaps in such a way that the apexes form a line.

3. Apparatus according to claim 1 and claim 2 characterised in that the rows of the plain bearings (3) are arranged in a carrier body (2) along or transversely with respect to the transport direction.

4. Apparatus according to claims 1 to 3 characterised in that the carrier body (2) comprises two portions and one portion of the carrier body (2) is designed for drive and for connection to the transport path (6) and the other portion of the carrier body (2) is designed for receiving the plain bearings (3) and for temperature control.

5. Apparatus according to claims 1 to 3 characterised in that a portion of the carrier body (2) is designed for temperature control, for drive and for connection to the transport path (6) and the other portion of the carrier body (2) is designed for receiving the plain bearings (3).

6. Apparatus according to claim 5 characterised in that the portion of the carrier body (2) which serves for receiving the plain bearings (3) is interchangeably connected to the carrier body (2).

7. Apparatus according to claims 1 to 6 characterised in that the portion of the carrier body (2), which serves for temperature control, comprises material which is a good conductor of heat, with a high specific thermal capacity, preferably copper.

8. Apparatus according to claim 1 characterised in that the electron beam vaporiser comprises a vaporiser dish (16) and an axial electron gun (14) arranged laterally thereof.

9. Apparatus according to claim 8 characterised in that the vaporiser dish (16) has in the bottom an opening for additionally supplying vaporisation material (17).

10. Apparatus according to at least one of claims 1 to 9 characterised in that the buffer regions (12; 18) are arranged within the second coating chamber (11).

11. Apparatus according to at least one of claims 1 to 9 characterised in that each buffer region (12; 18) is arranged in a separate vacuum chamber.

12. Apparatus according to at least one of claims 1 to 11 characterised in that a temperature control chamber (1) or a temperature control station is arranged upstream of the lock chamber (5) for temperature control of the carrier bodies (2).

13. Apparatus according to at least one of claims 1 to 12 characterised in that a device is arranged for returning the carrier bodies (2) from the lock chamber (19) at the exit end to the lock chamber (5) at the entry end.

14. Apparatus according to at least one of claims 1 to 13 characterised in that the vacuum chambers are arranged linearly with each other and the carrier bodies (2) are transported linearly from the lock chamber (5) at the entry end to the lock chamber (19) at the exit end.

15. Apparatus according to at least one of claims 1 to 13 characterised in that the vacuum chambers are arranged in a ring with each other and there is only one vacuum chamber for the airlock introduction and discharge of the carrier bodies (2).

16. Apparatus according to claim 1 characterised in that the etching device is so designed that the carrier bodies (2) with the plain bearings (3) are at earth potential and the magnetic field is in the form of a magnetron-like tunnel.

17. Apparatus according to at least one of claims 1 to 16 characterised in that the etching device (8) has fixed, arcuate portions which are electrically at earth potential and which together with the plain bearing elements (3) disposed in the movable carrier bodies (2) form an annularly closed region which delimits the plasma discharge, and a water-cooled counter-electrode which is at positive potential in relation to earth and which includes a magnetic field-generating device arranged at the rear, in the manner of a magnetron.

## Revendications

1. Dispositif de revêtement sous vide de paliers lisses comportant au moins une couche intermédiaire et au moins une couche de glissement, composé d'une série de chambres à vides qui sont disposées l'une après l'autre et séparées par des soupapes de dépression ou des paliers de pression, dans lequel au moins une chambre à vide sert de chambre sas pour amener sous vide les paliers lisses non revêtus et/ou pour sortir les paliers lisses revêtus hors du vide, dans lequel au moins une autre chambre à vide sert au pré-traitement des paliers lisses non revêtus par un processus au plasma et au moins une chambre à vide sert respectivement à appliquer la couche intermédiaire et la couche de glissement, des pompes à vide qui sont reliées aux chambres à vide, des dispositifs d'alimentation en courant et de dispositifs de commande pour réaliser les procédés de revêtement, ainsi que des moyens de transport de plusieurs paliers lisses sur une bande transporteuse traversant le dispositif, caractérisé en ce que
- les paliers lisses (3) sont maintenus par conjugaison de formes dans des corps de support (2),
- ces corps de support (2) peuvent être équilibrés en température,
- les paliers lisses (3) peuvent être serrés avec une force ajustable dans les corps de support,
- dans le sens du transport sont disposées l'une après l'autre au moins la chambre sas (5), une chambre de pré-traitement (7), une première chambre de revêtement (9), une seconde chambre de revêtement (11) et une chambre sas (19),
- le dispositif de commande est conçu de façon telle que les corps de support (2) peuvent être déplacés avec une vitesse de transport adaptable à chaque processus partiel se déroulant dans chaque chambre à vide,
- dans la chambre de pré-traitement (7) est disposé un dispositif d'attaque (8) destiné à l'attaque au plasma stationnaire, assisté par un champ magnétique, des paliers lisses (3),
- dans la première chambre de revêtement (9) est disposée une source de pulvérisation par magnétron (10), dans laquelle au moins une cible est pulvérisée, sous les paliers lisses (3), selon un écart adapté à la géométrie des paliers lisses (3),
- dans la seconde chambre de revêtement (11) est disposé un évaporateur à faisceau électronique comportant un creuset d'évaporateur (16), selon un écart adapté à la géométrie des paliers lisses (3),
- avant et après la zone dans laquelle les paliers lisses (3) sont revêtus par évaporation par faisceau électronique sont disposées des zones tampon (12; 18).

2. Dispositif selon la revendication 1, caractérisé en ce que dans un corps de support (2) sont disposés plusieurs paliers lisses (3) les uns à côté des autres et en continu, selon au moins une rangée, de façon telle que les sommets forment une ligne.

3. Dispositif selon la revendication 1 ou 2, caractérisé en ce que les rangées de paliers lisses (3) sont disposées dans un corps de support (2) le long de ou transversalement à la direction du transport.

4. Dispositif selon la revendication 1 à 3, caractérisé en ce que le corps de support (2) se compose de deux parties, et une partie du corps de support (2) est conçue pour entraîner et se relier à la bande transporteuse (6), l'autre partie du corps de support (2) étant conçue pour recevoir le palier lisse (3) et l'équilibrage en température.

5. Dispositif selon la revendication 1 à 3, caractérisé en ce qu'une partie du corps de support (2) est conçue pour équilibrer la température, pour entraîner et pour se relier à la bande transporteuse (6), et en ce que l'autre partie du corps de support (2) est conçue pour loger le palier lisse (3).

6. Dispositif selon la revendication 5, caractérisé en ce que la partie du corps de support (2) qui sert à loger le palier lisse (3) est reliée au corps de support (2) de façon échangeable.

7. Dispositif selon la revendication 1 à 6, caractérisé en ce que la partie du corps de support (2) servant à l'équilibrage de la température se compose d'un matériau bon conducteur de chaleur présentant une capacité thermique spécifique élevée, de préférence du cuivre.

8. Dispositif selon la revendication 1, caractérisé en ce que l'évaporateur à faisceau électronique se compose d'un creuset d'évaporateur (16) et d'un canon à électrons axial (14) disposé latéralement par rapport à celui-ci.

9. Dispositif selon la revendication 8, caractérisé en ce que le creuset d'évaporateur (16) possède dans son fond une ouverture d'amenée du matériau d'évaporation (17).

10. Dispositif selon au moins l'une des revendications 1 à 9, caractérisé en ce que les zones tampon (12 ; 18) sont disposées à l'intérieur de la seconde chambre de revêtement (11).

11. Dispositif selon au moins l'une des revendications 1 à 9, caractérisé en ce que chaque zone tampon (12 ; 18) est disposée dans une chambre à vide séparée.

12. Dispositif selon au moins l'une des revendications 1 à 11, caractérisé en ce que, pour équilibrer la température des corps de support (2), est disposé(e) avant la chambre sas (5) une chambre d'équilibrage de la température (1) ou un poste d'équilibrage de la température.

13. Dispositif selon au moins l'une des revendications 1 à 12, caractérisé en ce qu'est prévu un dispositif de retour des corps de support (2) depuis la chambre sas (19) côté sortie vers la chambre sas (5) côté entrée.

14. Dispositif selon au moins l'une des revendications 1 à 13, caractérisé en ce que les chambres à vide sont disposées linéairement les unes après les autres et en ce que les corps de support (2) sont transportés linéairement entre les chambres sas (5;19) du côté entrée vers le côté sortie.

15. Dispositif selon au moins l'une des revendications 1 à 13, caractérisé en ce que les chambres à vide sont disposées les unes après les autres en anneau et en ce que seule une chambre à vide est disposée pour l'éclusage en entrée et sortie des corps de support (2).

16. Dispositif selon la revendication 1, caractérisé en ce que le dispositif d'attaque est conçu de façon telle que les corps de support (2) sont reliés avec les paliers lisses (3) au potentiel terrestre et en ce que le champ magnétique est conçu en tant que tunnel de type magnétron.

17. Dispositif selon au moins l'une des revendications 1 à 16, caractérisé en ce que le dispositif d'attaque (8) possède des parties fixes, courbes, raccordées électriquement au potentiel terrestre, et qui forment avec les éléments lisses (3) se trouvant dans les corps de support mobiles (2) une zone fermée en anneau qui délimite la décharge de plasma, ainsi qu'une contre-électrode refroidie à l'eau à potentiel positif contre la terre, qui contient un dispositif de génération de champ magnétique disposé côté arrière de type magnétron.
